# EUROPEAN PATENT SPECIFICATION

(11) **EP 4 260 367 B1**
(45) Date of publication and mention of the grant of the patent: **03.06.2026**
(21) Application number: 20824486.3
(22) Date of filing: 09.12.2020
(51) Int. Cl.: H10W 40/00, H10W 40/10

(54) **HEAT SINK ARRANGEMENT, HEAT SINK AND ELECTRONIC CONTROL UNIT**
KÜHLKÖRPERANORDNUNG, KÜHLKÖRPER UND ELEKTRONISCHE STEUEREINHEIT
AGENCEMENT DE DISSIPATEUR THERMIQUE, DISSIPATEUR THERMIQUE ET UNITÉ DE COMMANDE ÉLECTRONIQUE

(43) Date of publication of application: 18.10.2023
(73) Proprietor: HELLA GmbH & Co. KGaA, 59552 Lippstadt (DE)
(72) Inventor: RAFEL, Arnaud, 31300 Toulouse (FR)
(74) Representative: Behr-Wenning, Gregor
(86) International application number: PCT/EP2020/085230
(87) International publication number: WO 2022/122146

(56) References cited:
- EP-A1- 3 751 970
- WO-A1-2014/066261
- WO-A1-2019/154307
- US-A1- 2005 046 017
- US-A1- 2006 060 963
- US-A1- 2009 244 852
- US-A1- 2019 271 819
- US-A1- 2020 066 612

## Description

The present invention relates to a heat sink arrangement for an electronic control unit comprising a heat sink with a first wall portion including a first outer surface of the heat sink and a second wall portion including a second outer surface of the heat sink, a first heat source located at the first outer surface of the first wall portion, and a second heat source located at the second outer surface of the second wall portion. The invention further relates to a heat sink for the heat sink arrangement and an electronic control unit comprising a heat sink arrangement.

US2020/0066612 A1 discloses a semiconductor device package. US2019/0271819 A1 discloses a thermal management system for multi-chip module and associated methods. WO2019/154307 A1 discloses a heat-insulation device and electronic product. WO2014/066261 A1 discloses an insulator module having structure enclosing atmospheric pressure gas. US2006/0060963 A1 discloses heat dissipation for chip-on-chip IC packages. US2005/0046017 A1 discloses a system and method using self-assembled nano structures in the design and fabrication of an integrated circuit micro-cooler. US2009/0244852 A1 discloses a heat radiator.

European patent application EP 2 071 620 A1 discloses a heat sink comprising a metallic heat conducting layer, a non-metallic heatsink layer combined with the metallic heat conducting layer and having a porous structure, and a hollow receiving space defined between the metallic heat conducting layer and the nonmetallic heatsink layer. Thus, the heat produced by a heat source fixed to the heat conducting layer is conducted quickly and distributed evenly onto the metallic heat conducting layer to create an even heat conducting effect, while the hollow receiving space has a heat convection effect to quickly transfer the heat from the metallic heat conducting layer to the non-metallic heatsink layer which produces a heatsink effect to dissipate the heat so that the heat is dissipated quickly by provision of the metallic heat conducting layer, the hollow receiving space and the non-metallic heatsink layer. Such a heat sink needs relatively much assembly space and the manufacturing process is complex.

In order to reduce packaging size as well as product weight and raw material usage, it is an alternative strategy to mount a plurality of heat radiating system components onto the same heat sink. As a result, system components are getting closer to each other. However, heat management is becoming more and more of an issue in such systems. Since the components will be located at the heat sink with great proximity to each other, the heat of one component maybe transferred into the heat sink and from there to another component at the heat sink. Hence, the radiating heat of one component might overheat the other component and/or at least negatively influences the function of the other component. The self-heating effect of the components being located at the same heat sink should thus be avoided.

It is an object of the present invention to overcome the above mentioned problems. In particular, it is an object of the present invention to provide an improved heat sink and/or heat sink arrangement.

Previously mentioned object is achieved by the subject-matters of the claims. In particular, the object is achieved by a heat sink arrangement according to claim 1, a heat sink according to claim 7, as well as an electronic control unit according to claim 8 of the present application. Further features and details of the invention can be drawn from the dependent claims, the description and the figures. Features and details discussed with respect to the inventive heat sink arrangement are also correlated with the inventive heat sink, the inventive electronic control unit and the other way around.

According to the present invention, a heat sink arrangement according to claim 1 is provided for an electronic control unit.

The heat sink is configured and arranged to absorb at least part of the heat emitted by the first heat source and the second heat source. By means of the at least one gap and/or the insulation means in the gap, a thermal connection between the first heat source and the second heat source can be reduced. Since the first heat source and the second heat source are connected to the same heat sink, the heat sink arrangement can still be provided compact and/or in a space saving manner.

The first heat source and the second heat source can be directly attached to the heat sink. In this case, the first heat source and the second heat source could be firmly bonded, glued and/or welded to the heat sink and the outer surface of the heat sink, respectively. At least part of the heat energy from the first heat source and from the second heat source can be transferred into the heat sink and the heat sink can be configured to transfer the absorbed heat energy from the first heat source and from the second heat source into other components via conduction, to evacuate the absorbed heat from the first heat source and from the second heat source into the environment of the heat sink arrangement via convection, and/or to process the heat energy by any combination of conduction and convection.

The heat sink arrangement has a thickness and/or a height in a height direction from the first heat source to the second heat source. In the height direction, it is preferred that the thickness and/or the height of the first wall portion is smaller than the thickness and/or the height of the gap between the first wall portion and the second wall portion. Further, in the height direction, it is preferred that the thickness and/or the height of the second wall portion is smaller than the thickness and/or the height of the gap between the first wall portion and the second wall portion. Optionally, even a combination of the height of the first wall portion and the height of the second wall portion can be smaller than the height of the gap between the first wall portion and the second wall portion.

It is further preferred that the first heat source, the second heat source and the gap are positioned at least partially above each other in the height direction. It is further preferred that there is only one gap between the first wall portion and the second wall portion, and this gap has a bigger width than each of the first heat source and the second heat source in a width direction that is perpendicular to the height direction. It is also preferred that the first heat source, the second heat source and the one gap are positioned concentric above each other in the height direction. By means of the described measures, heat conduction from the first heat source into the heat sink and from the second heat source into the heat sink will be allowed while still preventing or reducing at least a certain degree of heating interaction between the first heat source and the second heat source.

As an alternative to one single gap, there might be a plurality of gaps inside and/or at the heat sink. The first outer surface can be understood as an upper or right outer surface and the second outer surface can be understood as a lower or left outer surface, depending on the orientation of the heat sink arrangement and the heat sink, respectively. That is, the first outer surface and the second outer surface are preferably located on two opposing outer surfaces of the heat sink. The first outer surface thus shows preferably into another direction than the second outer surface. The insulation means may have an r-value above 3, preferably above 5 or above 10.

The electronic control unit can be understood as an electronic control unit (ECU) for a controller used to control system components like a steering wheel of a car. The first heat source and the second heat source can each be regarded as a component for performing desired functions for the electronic control unit. The first heat source and the second heat source may thus be a single heating component like a MOSFET-component, a complete power stage like an array of MOSFET-components or a circuit card assembly, for example.

The heat sink arrangement may comprise an electrical mass, wherein the heat sink is connected to electrical mass for electrical insulation between the first heat source and the second heat source. The heat sink is preferably made of metal. For example, the heat sink, in particular the whole heat sink, is made of aluminum. The material of the heat sink differs from the material of the insulation means. In particular, the material and/or substance of the insulation means preferably comprises a lower electrical and/or thermal conductivity than the material and/or substance of the heat sink. It is further preferred that the heat sink comprises a cuboid shape and/or a cuboid outer shape.

According to another embodiment of the present invention, it is possible that in a heat sink arrangement the at least one gap is part of at least one opening in the heat sink. That is, there can be at least one opening between the first wall portion and the second wall portion in, inside and/or at the heat sink. The at least one opening in the heat sink can be designed in an easy and cost-effective manner. The opening can be provided in the shape of a chamber, a hole, a through hole, a bore and/or a cavity in the heat sink.

Further, it is possible that the at least one opening of a heat sink arrangement according to the present invention forms a through hole or at least one through hole through the heat sink for guiding an insulation fluid through the heat sink and between the first wall portion and the second wall portion. By means of the insulation fluid flowing through the through hole, an effective thermal insulation can be achieved. The through hole is preferably configured to guide the insulation fluid in a flowing direction perpendicular to the above described height direction. The through hole may have a rectangular or essentially rectangular cross-section.

Moreover, it is possible that the at least one gap of an inventive heat sink arrangement is part of a chamber in the heat sink. The chamber provides a solution at low costs that can be easily manufactured. In addition, such solution can be realized in a compact form. The chamber can be understood as a closed room and/or space within or inside the heat sink. The chamber may form the gap. The heat sink can be designed as a molded body that comprises and/or has formed the chamber therein. The heat sink can be manufactured from two half shells, which are firmly bonded together in order to form the chamber therebetween and/or therein. The insulation means in the chamber can be provided as gas, for example air, or a solid insulation material for the desired thermal insulation between the first heat source and the second heat source.

In addition, in a heat sink arrangement not forming part of the present invention, the insulation means may comprise a vacuum in the chamber. When providing the vacuum in the chamber, the desired insulation can be provided in a cheap and still effective manner. In order to provide the vacuum in the chamber, there might be a fluid channel in the heat sink from an outer surface into the chamber, through which air can be sucked out from the chamber.

According to another embodiment not forming part of the present invention, it is possible that the insulation means of a heat sink arrangement comprises insulation gas provided in the at least one gap for the thermal insulation between the first heat source and the second heat source. In particular, air can be used as the insulation gas and the insulation means, respectively. This would be a cheap solution that is easy to realize.

Furthermore, in a heat sink arrangement of the present invention, the insulation means comprises a solid insulation material provided in the at least one gap for the thermal insulation between the first heat source and the second heat source. The solid material may comprise cellulose, gel, fibers and/or foam.

In a preferred embodiment of the present invention, the heat sink arrangement may comprise a heat sink having a monolithic structure. A heat sink with a monolithic structure can be understood as a monolithic heat sink in one piece and/or a heat sink that is made of one single material or essentially of one single material only. A monolithic structure can also be provided by firmly bonding two half shelfs together. By providing a monolithic heat sink, the heat sink arrangement can be provided in an easy and cost-effective manner. The heat sink is preferably made of aluminum and/or aluminum only.

In accordance with another aspect of the invention, a heat sink for the above described heat sink arrangement is provided. The heat sink comprises a first wall portion including a first outer surface of the heat sink, a second wall portion including a second outer surface of the heat sink, at least one gap between the first wall portion and the second wall portion, and an insulation means provided in the gap for thermal insulation between the first heat source and the second heat source. Therefore, the inventive heat sink brings up the same advantages that have been discussed in detail with respect to the inventive heat sink arrangement. The at least one gap between the first wall portion and the second wall portion can be understood as a gap and/or a hollow space between a first inner surface of the first wall portion and a second inner surface of the second wall portion.

A further aspect of the present invention relates to an electronic control unit comprising at least one heat sink arrangement as described above. The electronic control unit therefore also includes the advantages mentioned above. The electronic control unit may comprise one or more heat sinks, wherein each heat sink may have a plurality of heat sourced attached thereto.

Further measures improving the inventive concept can be drawn from the following description of preferred embodiments, which are schematically shown in the drawings. The features and advantages, which can be drawn from the claims, from the description and from the drawings, might be considered essential alone or in combination with each other.

The present invention is discussed in more detail with respect to the accompanying drawings, in which
- Fig. 1: shows a cross-section view of a heat sink arrangement according to a first embodiment of the present invention,
- Fig. 2: shows a top view of the heat sink arrangement according to the first embodiment of the present invention,
- Fig. 3: shows a top view of the heat sink arrangement according to a second embodiment of the present invention,
- Fig. 4: shows a top view of the heat sink arrangement according to a third embodiment of the present invention,
- Fig. 5: shows a top view of the heat sink arrangement according to a fourth embodiment of the present invention, and
- Fig. 6: shows an electronic control unit with a heat sink arrangement according to the present invention.

In the drawings, elements and features having the same function and operating principle are labeled with the same reference signs

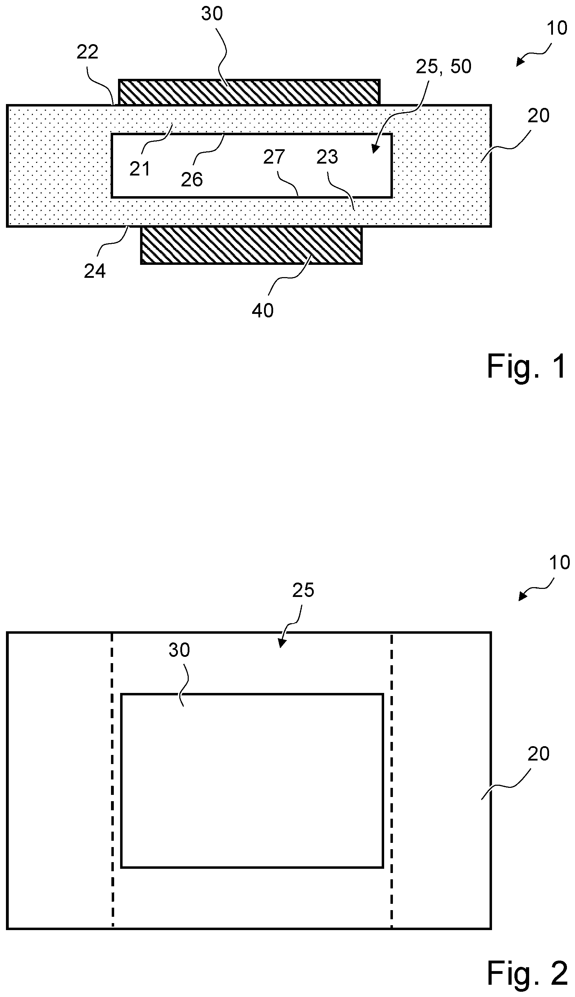

Fig. 1 shows a heat sink arrangement 10 for an electronic control unit 100 according to a first embodiment. The heat sink arrangement 10 of Fig. 1 comprises a monolithic heat sink 20 with a first wall portion 21 including a first outer surface 22 of the heat sink 20 and a second wall portion 23 including a second outer surface 24 of the heat sink 20. The heat sink 20 further comprises a first heat source 30 located at the first outer surface 22 of the first wall portion 21 and a second heat source 40 located at the second outer surface 24 of the second wall portion 23. The first outer surface 22 and the second outer surface 24 are located opposed to each other. That is, they point in different directions showing away from each other. Thus, the first outer surface 22 can be regarded as an upper outer surface on top of the heat sink 20 and the second outer surface 24 can be regarded as a lower outer surface at the bottom of the heat sink 20.

The heat sink 20 shown in Fig. 1 comprises a gap 25 between the first wall portion 21 and the second wall portion 23. In particular, the gap 25 is part of an opening in the heat sink 20. In other words, an opening in the heat sink 20 forms the gap 25. In that opening, an insulation means 50 is provided for thermal insulation between the first heat source 30 and the second heat source 40. Even though it is still possible that there is thermal conduction over the heat sink 20 from the first heat source 30 to the second heat source 40 or the other way around, the insulation means 50 reduces this effect in comparison to a heat sink 20 that would not have the gap 25 or the insulation means 50.

As can be seen in Fig. 1, the opening is formed between a first inner surface 26 and a second inner surface 27 of the heat sink 20, the opening and the gap 25, respectively. The first inner surface 26 and the second inner surface 27 are facing each other. Further, the heat sink 20 of Fig. 1 is made of aluminum. The heat sink arrangement 10 has a height in a height direction from the first heat source 30 to the second heat source 40. In the height direction, the height of the first wall portion 21 is smaller than the height of the gap 25 between the first wall portion 21 and the second wall portion 23. Further, in the height direction, the height of the second wall portion 23 is smaller than the height of the gap 25 between the first wall portion 21 and the second wall portion 23.

The first heat source 30, the second heat source 40 and the gap 25 are positioned above each other in the height direction. The gap 25 has a bigger width than each of the first heat source 30 and the second heat source 40 in a width direction that is perpendicular to the height direction. Moreover, the first heat source 30, the second heat source 40 and the gap 25 are positioned concentric above each other in the height direction.

Fig. 2 shows a top view onto the heat sink arrangement 10 shown in Fig. 1 according to the first embodiment. As can be seen in Fig. 2, the opening forms a through hole through the heat sink 20 for guiding an insulation fluid through the heat sink 20 and between the first wall portion 21 and the second wall portion 23. The through hole as a rectangular cross-section. Said insulation fluid could be air from the environment of the heat sink arrangement 10. The insulation fluid could also be a fluid that is guided through the through hole by means of a pump, for example.

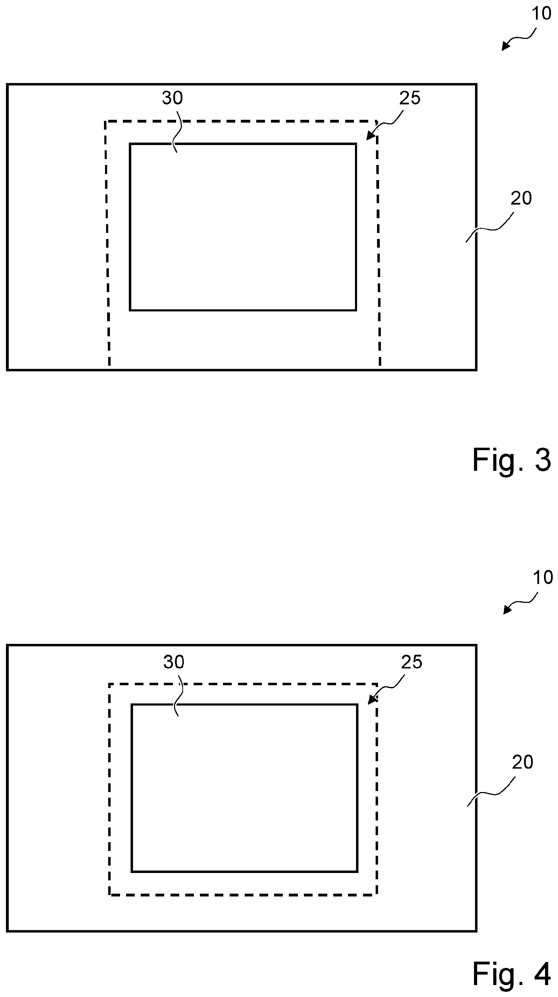

In Fig. 3, a second embodiment of the heat sink arrangement 10 is shown in which the gap 25 is part of a cavity in the heat sink 20 that is open to only one side of the environment of the heat sink arrangement 10. The insulation means 50 in this embodiment in accordance with the present invention comprises a solid insulation material for the thermal and/or electrical insulation between the first heat source 30 and the second heat source 40.

In accordance with a third embodiment of a heat sink arrangement 10 shown in Fig. 4, the gap 25 is part of a chamber in the heat sink 20. The chamber forms a closed, hollow space inside the heat sink 20. In the example of Fig. 4, the insulation means 50 inside the chamber is realized as a vacuum in the chamber.

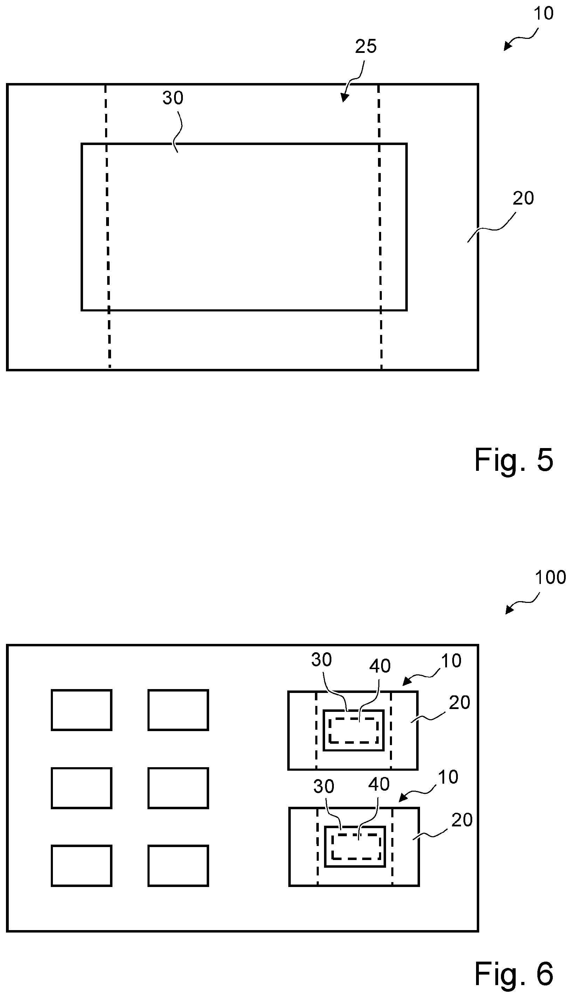

Fig. 5 shows a heat sink arrangement 10 according to a fourth embodiment, in which the width of the first heat source 30 in the width direction (direction from left to right in Fig. 5) is bigger that the width of the gap 25 and the opening, respectively.

In Fig. 6, an electronic control unit 100 is shown, which comprises a heat sink arrangement 10 having two heat sinks 20, wherein each heat sink 20 has a first heat source 30 and a second heat source 40 attached thereto.

### Reference signs

- 10: heat sink arrangement
- 20: heat sink
- 21: first wall portion
- 22: first outer surface
- 23: second wall portion
- 24: second outer surface
- 25: gap
- 26: first inner surface
- 27: second inner surface
- 30: first heat source
- 40: second heat source
- 50: insulation means
- 100: electronic control unit

## Claims

1. Heat sink arrangement (10) for an electronic control unit (100), comprising:
- a heat sink (20) with a first wall portion (21) including a first outer surface (22) of the heat sink (20) and a second wall portion (23) including a second outer surface (24) of the heat sink (20),
- a first heat source (30) located at the first outer surface (22) of the first wall portion (21), and
- a second heat source (40) located at the second outer surface (24) of the second wall portion (23),
at least one gap (25) between the first wall portion (21) and the second wall portion (23), wherein an insulation means (50) is provided in the gap (25) for thermal insulation between the first heat source (30) and the second heat source (40),
the at least one gap (25) is part of at least one opening in the heat sink (20), the first outer surface (22) and the second outer surface (24) are located opposed to each other, and
**characterized in that**
the insulation means (50) comprises a solid insulation material provided in the at least one gap (25) for the thermal and/or electrical insulation between the first heat source (30) and the second heat source (40).

2. Heat sink arrangement (10) according to claim 1, wherein the at least one opening forms a through hole through the heat sink (20) for guiding an insulation fluid through the heat sink (20) and between the first wall portion (21) and the second wall portion (23).

3. Heat sink arrangement (10) according to any one of the above claims, wherein the at least one gap (25) is part of a chamber in the heat sink (20).

4. Heat sink arrangement (10) according to claim 3, wherein the insulation means (50) comprises a vacuum in the chamber.

5. Heat sink arrangement (10) according to any one of the above claims, wherein the insulation means (50) comprises insulation gas provided in the at least one gap (25) for the thermal insulation between the first heat source (30) and the second heat source (40).

6. Heat sink arrangement (10) according to any one of the above claims, wherein the heat sink (20) comprises a monolithic structure.

7. Heat sink (20) for the heat sink arrangement (10) according to any one of the above claims, comprising a first wall portion (21) including a first outer surface (22) of the heat sink (20), a second wall portion (23) including a second outer surface (24) of the heat sink (20), at least one gap (25) between the first wall portion (21) and the second wall portion (23), and an insulation means (50) provided in the gap (25) for thermal insulation between the first heat source (30) and the second heat source (40).

8. Electronic control unit (100) comprising the at least one heat sink arrangement (10) according to any one of claims 1 to 6.

## Patentansprüche

1. Kühlkörperanordnung (10) für eine elektronische Steuereinheit (100), umfassend:
- einen Kühlkörper (20) mit einem ersten Wandabschnitt (21), umfassend eine erste Außenfläche (22) des Kühlkörpers (20), und einem zweiten Wandabschnitt (23), umfassend eine zweite Außenfläche (24) des Kühlkörpers (20),
- eine erste Wärmequelle (30), positioniert an der ersten Außenfläche (22) des ersten Wandabschnitts (21), und
- eine zweite Wärmequelle (40), positioniert an der zweiten Außenfläche (24) des zweiten Wandabschnitts (23),
mindestens einen Spalt (25) zwischen dem ersten Wandabschnitt (21) und dem zweiten Wandabschnitt (23), wobei in dem Spalt (25) ein Isolationsmittel (50) für thermische Isolation zwischen der ersten Wärmequelle (30) und der zweiten Wärmequelle (40) bereitgestellt ist,
wobei der mindestens eine Spalt (25) Teil mindestens einer Öffnung in dem Kühlkörper (20) ist und die erste Außenfläche (22) und die zweite Außenfläche (24) einander gegenüber positioniert sind, und
**dadurch gekennzeichnet, dass**
das Isolationsmittel (50) ein festes Isolationsmaterial, bereitgestellt in dem mindestens einen Spalt (25) für die thermische und/oder elektrische Isolation zwischen der ersten Wärmequelle (30) und der zweiten Wärmequelle (40), umfasst.

2. Kühlkörperanordnung (10) nach Anspruch 1,
wobei
die mindestens eine Öffnung ein Durchgangsloch durch den Kühlkörper (20) zum Leiten eines Isolationsfluides durch den Kühlkörper (20) und zwischen dem ersten Wandabschnitt (21) und dem zweiten Wandabschnitt (23) bildet.

3. Kühlkörperanordnung (10) nach einem der vorhergehenden Ansprüche,
wobei
der mindestens eine Spalt (25) Teil einer Kammer in dem Kühlkörper (20) ist.

4. Kühlkörperanordnung (10) nach Anspruch 3,
wobei
das Isolationsmittel (50) ein Vakuum in der Kammer umfasst.

5. Kühlkörperanordnung (10) nach einem der vorhergehenden Ansprüche,
wobei
das Isolationsmittel (50) Isolationsgas, bereitgestellt in dem mindestens einen Spalt (25) für die thermische Isolation zwischen der ersten Wärmequelle (30) und der zweiten Wärmequelle (40), umfasst.

6. Kühlkörperanordnung (10) nach einem der vorhergehenden Ansprüche,
wobei
der Kühlkörper (20) eine monolithische Struktur umfasst.

7. Kühlkörper (20) für die Kühlkörperanordnung (10) nach einem der vorhergehenden Ansprüche, umfassend einen ersten Wandabschnitt (21) mit einer ersten Außenfläche (22) des Kühlkörpers (20), einen zweiten Wandabschnitt (23) mit einer zweiten Außenfläche (24) des Kühlkörpers (20), mindestens einen Spalt (25) zwischen dem ersten Wandabschnitt (21) und dem zweiten Wandabschnitt (23) und ein Isolationsmittel (50), bereitgestellt in dem Spalt (25) für thermische Isolation zwischen der ersten Wärmequelle (30) und der zweiten Wärmequelle (40).

8. Elektronische Steuereinheit (100), umfassend die mindestens eine Kühlkörperanordnung (10) nach einem der Ansprüche 1 bis 6.

## Revendications

1. Dispositif de dissipateur thermique (10) pour une unité de contrôle électronique (100) comprenant :
- un dissipateur thermique (20) avec une première section de paroi (21) comprenant une première surface extérieure (22) du dissipateur thermique (20) et une deuxième section de paroi (23) comprenant une deuxième surface extérieure (24) du dissipateur thermique (20),
- une première source de chaleur (30) située au niveau de la première surface extérieure (22) de la première section de paroi (21) et
- une deuxième source de chaleur (40) située au niveau de la deuxième surface extérieure (24) de la deuxième section de paroi (23),
au moins un espace (25) entre la première section de paroi (21) et la deuxième section de paroi (23), un moyen d'isolation (50) étant prévu dans l'espace (25) pour l'isolation thermique entre la première source de chaleur (30) et la deuxième source de chaleur (40),
au moins un espace (25) faisant partie d'au moins une ouverture dans le dissipateur thermique (20), la première surface extérieure (22) et la deuxième surface extérieure (24) étant situées l'une en face de l'autre, et
**caractérisé en ce que**
le moyen d'isolation (50) comprend un matériau d'isolation solide prévu au moins dans un espace (25) pour l'isolation thermique et/ou électrique entre la première source de chaleur (30) et la deuxième source de chaleur (40).

2. Un dispositif de dissipateur thermique (10) selon la revendication 1
sachant que
au moins une ouverture forme un trou traversant dans le dissipateur thermique (20) pour guider un fluide isolant à travers le dissipateur thermique (20) et entre la première section de paroi (21) et la deuxième section de paroi (23).

3. Un dispositif de dissipateur thermique (10) selon l'une des revendications
précédentes
sachant que
au moins un espace (25) fait partie d'une chambre dans le dissipateur thermique (20).

4. Un dispositif de dissipateur thermique (10) selon la revendication 3
sachant que
le moyen d'isolation (50) comprend un vide dans la chambre.

5. Un dispositif de dissipateur thermique (10) selon l'une des revendications
précédentes
sachant que
le moyen d'isolation (50) comprend un gaz isolant prévu au moins dans un espace (25) pour l'isolation thermique entre la première source de chaleur (30) et la deuxième source de chaleur (40).

6. Un dispositif de dissipateur thermique (10) selon l'une des revendications
précédentes
sachant que
le dissipateur thermique (20) comprend une structure monolithique.

7. Dissipateur thermique (20) pour le dispositif de dissipateur thermique (10) selon l'une des revendications précédentes avec une première section de paroi (21) comprenant une première surface extérieure (22) du dissipateur thermique (20), une deuxième section de paroi (23) comprenant une deuxième surface extérieure (24) du dissipateur thermique (20), au moins un espace (25) entre la première section de paroi (21) et la deuxième section de paroi (23) et un moyen d'isolation (50) prévu dans l'espace (25) pour l'isolation thermique entre la première source de chaleur (30) et la deuxième source de chaleur (40).

8. Unité de contrôle électronique (100) comprenant au moins un dispositif de dissipateur thermique (10) selon l'une des revendications 1 à 6.
